Europäisches Patentamt

European Patent Office

Office européen des brevets

(19)

(11) Publication number: **0 311 420**
**A2**

(12) **EUROPEAN PATENT APPLICATION**

(21) Application number: **88309368.4**

(22) Date of filing: **07.10.88**

(51) Int. Cl.⁴: **H 01 L 27/12**

(30) Priority: **09.10.87 JP 255685/87**
**09.10.87 JP 255684/87**

(43) Date of publication of application:
**12.04.89 Bulletin 89/15**

(84) Designated Contracting States: **DE FR GB**

(71) Applicant: **FUJITSU LIMITED**
**1015, Kamikodanaka Nakahara-ku**
**Kawasaki-shi Kanagawa 211 (JP)**

(72) Inventor: **Gotou, Hiroshi**
**1-16-2-105, Nobidome**
**Niiza-shi Saitama 352 (JP)**

(74) Representative: **Fane, Christopher Robin King et al**
**HASELTINE LAKE & CO. Hazlitt House 28 Southampton**
**Buildings Chancery Lane**
**London, WC2A 1AT (GB)**

(54) **Semiconductor device having silicon on insulator structure.**

(57) A semiconductor device has a base substrate (31, 41) made of a conductor or a semiconductor, an insulator layer (32, 42) formed on the base substrate, and an active layer (33. 43) in which elements are formed, where the active layer is formed on the insulator layer and is made of a semiconductor. A potential difference (Vr) is introduced across the base substrate and the active layer in such a direction that a depletion layer (34, 51) formed in a vicinity of an interface of the insulator layer and the active layer.

FIG. 3

FIG. 4

EP 0 311 420 A2

**Description**

## SEMICONDUCTOR DEVICE HAVING SILICON ON INSULATOR STRUCTURE

BACKGROUND OF THE INVENTION

The present invention generally relates to semiconductor devices, and more particularly to a semiconductor device having a silicon on insulator (hereinafter simply referred to as an SOI) structure.

A soft error occurs when a large amount of electron-hole pairs is generated in a semiconductor and a large current flows due to radiation emitted from a radioactive material. In the case of a semiconductor device having a memory function, the soft error causes a temporary derangement in a memory portion and an information stored in the memory portion may become destroyed.

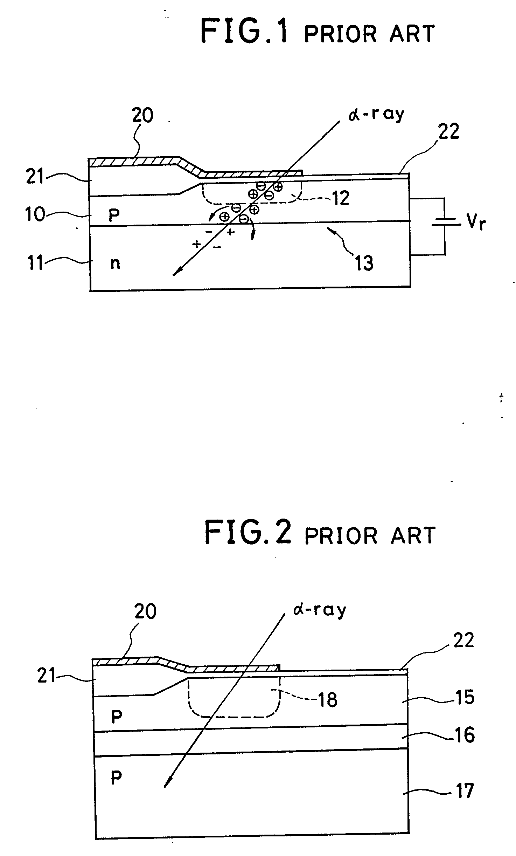

Conventionally, there are two measures against the soft error. FIG.1 shows a conventional semiconductor device employing a first method which uses a pn junction, and FIG.2 shows a conventional semiconductor device employing a second method which uses an SOI structure.

In FIG.1, the semiconductor device has a p-type layer 10, an n-type layer 11, a capacitor region 12 which corresponds to a memory cell, for example, a cell plate 20, a field oxide region 21, and an oxide layer 22. A depletion layer 13 is formed in a vicinity of a pn junction between the p-type layer 10 and the n-type layer 11 by applying a reverse bias voltage Vr across the p-type layer 10 and the n-type layer 11. Accordingly, even when a large amount of electron-hole pairs is generated in the p-type layer 10 and the n-type layer 11 due to an $\alpha$-ray, the pn junction prevents carriers in the n-type layer 11 from diffusing into the capacitor region 12 while carriers in the p-type layer 10 move in a direction of the n-type layer 11 and are prevented from diffusing into the capacitor region 12 due to the reverse biasing.

In FIG.2, the semiconductor device has a p-type layer 15, an insulator layer 16, a p-type layer 17, a capacitor region 18, the cell plate 20, the field oxide region 21, and the oxide layer 22. The semiconductor device having such an SOI structure has advantageous features in that i) it is possible to prevent a latch up in a complementary metal oxide semiconductor (CMOS), ii) a parasitic (or stray) capacitance can be reduced because it is possible to make a substrate thin and a high speed operation of the device can be realized, and iii) the soft error does not occur easily by the $\alpha$-ray and other radiation. The SOI structure makes it possible to suppress the occurrence of the soft error because the p-type layer 15 is extremely thin and the amount of electron-hole pairs generated in the p-type layer 15 due to the radiation is small, and the carriers in the p-type layer 15 diffusing into the capacitor region 18 is small in number.

However, even in the case of the SOI structure, there do exist carriers in the p-type layer 15 diffusing into the capacitor region 18 and the soft error may occur. For this reason, it is desirable to further suppress the occurrence of the soft error in the SOI structure while maintaining the advantageous features i) and ii) of the SOI structure described above. As a method of further suppressing the occurrence of the soft error in the SOI structure, it is conceivable to use the pn junction shown in FIG.1 in the SOI structure and apply the reverse bias voltage. But according to the present production techniques, it is impossible to form layers having a satisfactory crystal state at the pn junction interface and it is essential that the p-type layer and the n-type layer are formed to predetermined thicknesses which are not extremely thin. Hence, it is impossible to form extremely thin p-type layer and n-type layer in the SOI structure so as to obtain a pn junction. In addition, when a p-type layer and an n-type layer having the predetermined thicknesses are formed in the SOI structure, it becomes impossible to maintain the advantageous features i) and ii) of the SOI structure.

On the other hand, in the conventional semiconductor device having the SOI structure, a portion of a source region or a drain region makes contact with an insulator layer. Hence, a back channel is generated when a voltage applied to a base substrate is greater than a voltage of an active layer, and a leakage current is generated between the source and the drain. For this reason, a voltage is conventionally applied to the base substrate in such a direction that the generation of the back channel is prevented.

Therefore, in the conventional semiconductor device having the SOI structure, the occurrence of the soft error is suppressed to a certain extent but there is a problem in that it is impossible to more positively prevent the occurrence of the soft error while maintaining the advantageous features of the SOI structure.

SUMMARY OF THE INVENTION

Accordingly, it is a general object of the present invention to provide a novel and useful semiconductor device in which the problems described above are eliminated.

Another and more specific object of the present invention is to provide a semiconductor device having a base substrate made of a conductor or a semiconductor, an insulator layer formed on the base substrate, an active layer in which elements are formed, where the active layer is formed on the insulator layer and is made of a semiconductor, and means for introducing a potential difference across the base substrate and the active layer in such a direction that a depletion layer is formed in a vicinity of an interface of the insulator layer and the active layer. According to the semiconductor device of the present invention, carriers in the active layer move in a direction of the depletion layer and the carriers are prevented from diffusing into an element region of the active layer even when electron-hole pairs are generated in the active layer due to radiation. For this reason, it is possible to more positively prevent the generation of the soft error.

Still another object of the present invention is to provide a semiconductor device of the above described structure in which another insulator layer is provided on at least a side surface of one of the base substrate and the active layer. According to the semiconductor device of the present invention, it is possible to prevent a leakage current from flowing from the base substrate to the active layer, and the reliability of the semiconductor device is greatly improved.

Other objects and further features of the present invention will be apparent from the following detailed description when read in conjunction with the accompanying drawings.

BRIEF DESCRIPTION OF THE DRAWINGS

FIG.1 is a cross sectional view showing a conventional semiconductor device using a pn junction for suppressing an occurrence of a soft error due to radiation;

FIG.2 is a cross sectional view showing a conventional semiconductor device using an SOI structure for suppressing an occurrence of a soft error due to radiation;

FIG.3 is a cross sectional view for explaining the operating principle of the semiconductor device according to the present invention;

FIG.4 is a cross sectional view showing a first embodiment of the semiconductor device according to the present invention;

FIGS.5A and 5B are cross sectional views respectively showing an essential part of first and second modifications of the first embodiment;

FIGS.6A and 6B are a plan view and a cross sectional view respectively showing a 64k SOI-DRAM;

FIG.7 is a diagram for explaining a method of detecting a soft error generated within the DRAM;

FIG.8 shows a characteristic for explaining a dependency of the soft error on a thickness of an active layer;

FIG.9 shows a characteristic for explaining a dependency of the soft error on a voltage of a base substrate;

FIG.10 is a cross sectional view showing a second embodiment of the semiconductor device according to the present invention;

FIG.11 is a cross sectional view showing a modification of the second embodiment;

FIG.12 is a cross sectional view showing a third embodiment of the semiconductor device according to the present invention;

FIG.13 is a cross sectional view showing a fourth embodiment of the semiconductor device according to the present invention; and

FIG.14 is a cross sectional view showing a fifth embodiment of the semiconductor device according to the present invention.

DETAILED DESCRIPTION

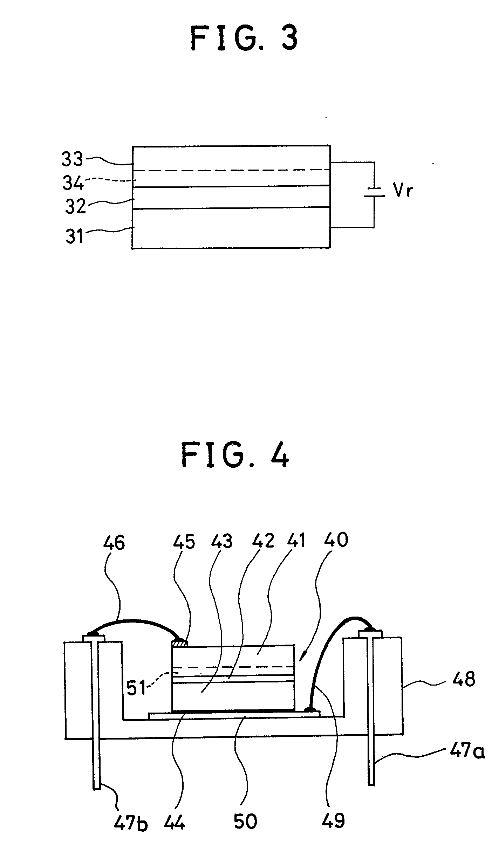

First, a description will be given of the operating principle of the semiconductor device according to the present invention, by referring to FIG.3. In FIG.3, the semiconductor device has a support layer 31 made of a metal or a semiconductor, an insulator layer 32 formed on the base substrate 31, and an active layer 33 made of a semiconductor in which elements are formed.

A potential difference Vr is applied across the base substrate 31 and the active layer 33 in such a direction that a depletion layer 34 is formed in a vicinity of an interface of the insulator layer 32 and the active layer 33. Accordingly, even when the electron-hole pairs are generated in the active layer 33 due to radiation, the carriers in the active layer 33 move in a direction of the depletion layer 34 and are prevented from diffusing into an element region of the active layer 33. Therefore, the occurrence of the soft error is positively prevented.

FIG.4 shows a first embodiment of the semiconductor device according to the present invention. In FIG.4, a semiconductor device has a stacked structure 40 made up of a p-type base substrate 41 made of a metal or a semiconductor, an insulator layer 42, and a p-type active layer 43 in which elements of the semiconductor device are formed. In this embodiment, the stacked structure 40 is accommodated within a package 48 in a state where the stacked structure 40 is adhered on a connecting part 50 by a back surface adhering part 44. A wire 49 for applying a reverse bias voltage has one end thereof connected to the connecting part 50 and the other end thereof conneted to a socket pin 47a. The base substrate 41 is electrically coupled to the socket pin 47a by the wire 49. In addition, a bonding wire 46 has one end thereof connected to a bonding pad 45 on the active layer 43 and the other end thereof connected to a socket pin 47b. The active layer 43 is electrically coupled to the socket pin 47b by the bonding wire 46.

For example, a voltage -3V of the active layer 43 is generated in an internal circuit of the semiconductor device in this embodiment, and no special wire is used to supply a voltage from the outside. However, it is of course possible to apply the voltage of the active layer 43 from outside the semiconductor device. On the other hand, a voltage of the base substrate 41 is applied from a back surface of the base substrate 41. As a result, a potential difference is introduced across the base substrate 41 and the active layer 43 in such a direction that a depletion layer 51 is formed in a vicinity of an interface of the insulator layer 42 and the active layer 43.

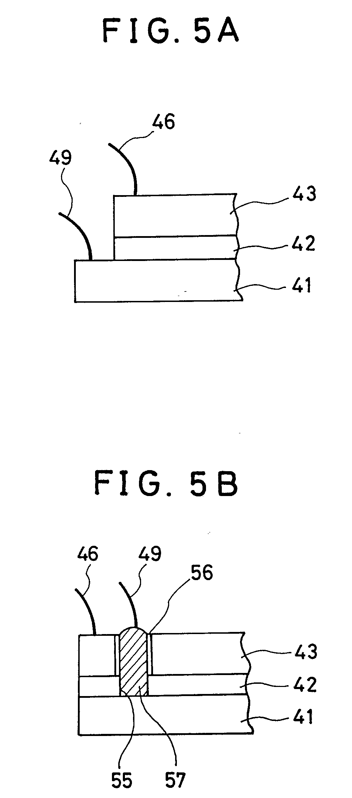

FIGS.5A and 5B respectively show first and second modifications of the first embodiment. In a first modification shown in FIG.5A, a step is made between the base substrate 41 and the layers 42 and 43, and the wire 49 is connected directly to the stepped portion of the base substrate 41.

In a second modification shown in FIG.5B, a contact hole 55 is formed in the active layer 43 and the insulator layer 42 and reaches the base substrate 41. An insulator layer 56 is formed on a side wall of the active layer 43 defining the contact hole 55. A conductor 57 fills the contact hole 55 and the wire 49 connects to the conductor 57.

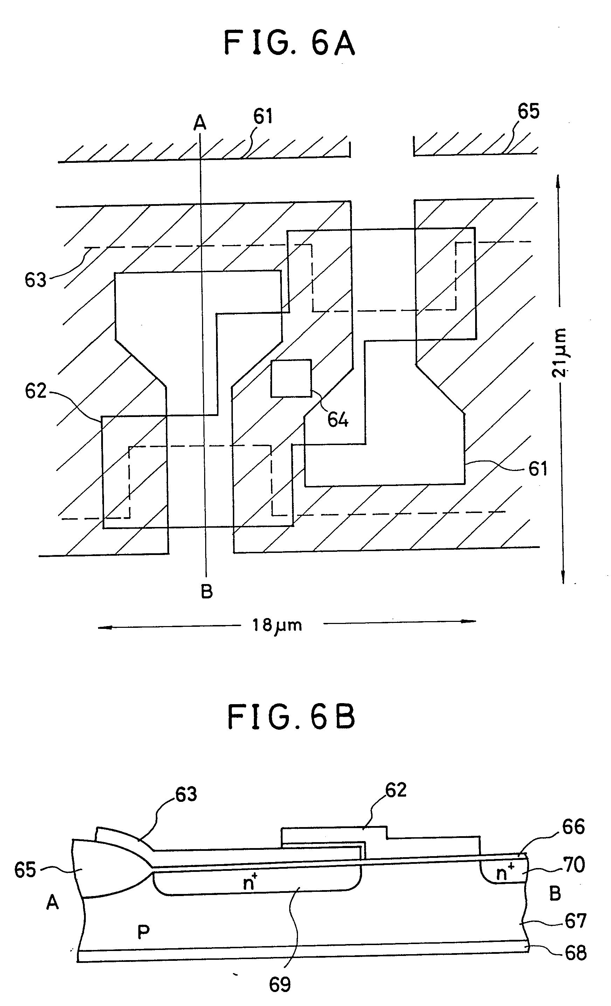

Next, a description will be given of a 64k SOI-DRAM (Dynamic Random Access Memory) having the base substrate, the insulator layer and the active layer (that is, the stacked structure) as in the case of the semiconductor device shown in FIG.4. FIG.6A shows a plan view of the 64k SOI-DRAM and FIG.6B shows a cross sectional view of the 64k SOI-DRAM along a line A-B in FIG.6A.

In FIG.6A, the 64k SOI-DRAM has a diffusion layer 61, a gate electrode 62, a cell plate 63, a contact hole 64 for use in making contact with a word line (not shown), and a field oxide region 65. The gate electrode 62 and the cell plate 63 are respectively made of polysilicon having a thickness of 5000 Å, and the size of one cell is approximately 9 microns x 12 microns.

In FIG.6B, the 64k SOI-DRAM has an oxide layer 66, a p-type silicon (Si) active layer 67, a silicon dioxide ($SiO_2$) insulator layer 68, an $n^+$-type source region (capacitor region) 69, and an $n^+$-type drain region 70. Compared to the conventional semiconductor device having the SOI structure in which a portion of the source region or the drain region makes contact with the insulator layer, such a semiconductor device in which a portion of the source region or the drain region does not make contact with the insulator layer was advantageous when the characteristics such as the leakage current and the production method were considered but was disadvantageous when the soft error was considered. However, according to the present invention, it is possible to effectively prevent the soft error even in the semiconductor device in which a portion of the source region or the drain region does not make contact with the insulator layer.

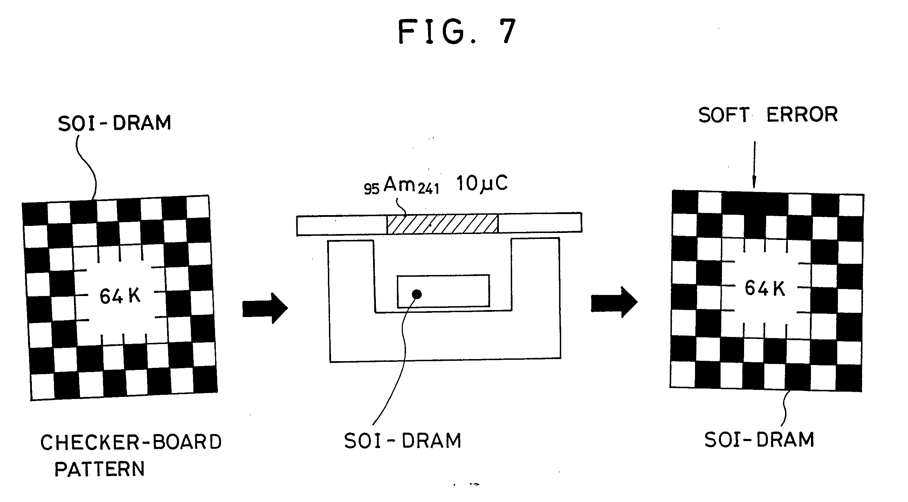

The present inventor detected the soft error generated in the 64k SOI-DRAM by a method described hereunder in conjunction with FIG.7. First, an information was written into the SOI-DRAM in a checkered pattern. Then, this SOI-DRAM was subjected to the effects of radiation by using americium ($_{95}Am_{241}$) as a source of generating the α-ray, and the SOI-DRAM was placed under a condition of 10 micro-Coulombs for a time of one minute. Thereafter, the soft error generated within the SOI-DRAM was detected.

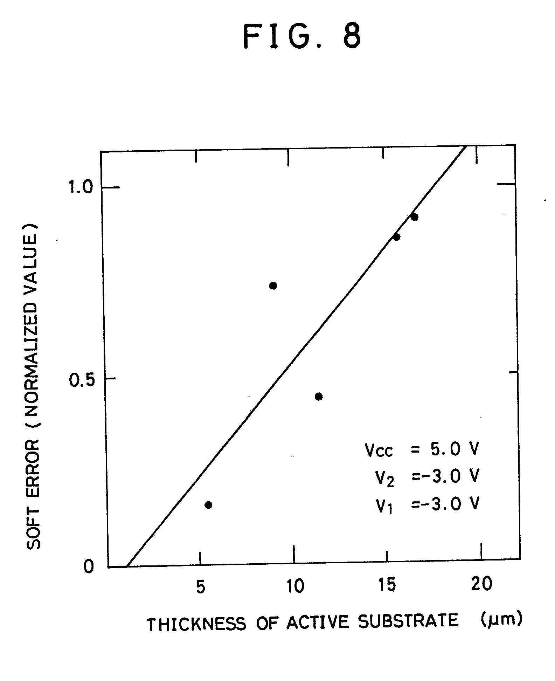

FIG.8 shows a dependency of the soft error on the thickness of the active layer measured from the detection of the soft error generated in the SOI-DRAM. This characteristic was obtained by using a p-type Si layer having a thickness of 500 microns as the base substrate, an $SiO_2$ layer having a thickness of 0.8 micron as the insulator layer, and a p-type Si layer as the active layer. A power source voltage Vcc was set to 5.0 V, a base substrate voltage V1 was set to -3.0 V, and an active layer voltage V2 was set to -3.0 V. From the characteristic shown in FIG.8, it can be seen that the soft error is reduced when the thickness of the active layer is 20 microns or less, and it was confirmed that the soft error becomes approximately 1/10 that of the conventional DRAM using the normal wafer when the thickness of the active layer is approximately 4 microns.

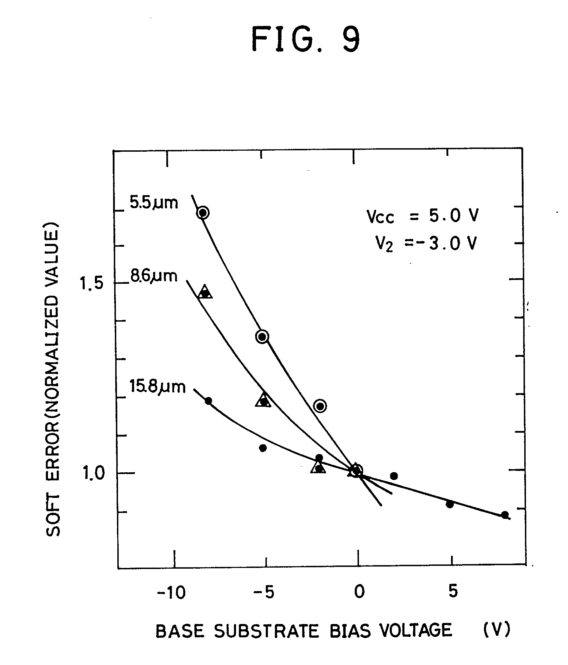

FIG.9 shows a dependency of the soft error on the voltage of the base substrate measured from the detection of the soft error generated in the SOI-DRAM. This characteristic was obtained by using a base substrate and an insulator layer indentical to those used in obtaining the characteristic shown in FIG.8. Three kinds of p-type Si layers respectively having thicknesses of 5.5 microns, 8.6 microns and 15.8 mirons were used as the active layer. In addition, the power source voltage Vcc and the active layer voltage V2 were also set to the same voltages used in obtaining the characteristic shown in FIG.8. From the characteristic shown in FIG.9, it can be seen that the soft error is reduced when the base substrate voltage V1 is a positive bias voltage with reference to the source potential, and it was confirmed that the rate with which the soft error is reduced becomes greater as the thickness of the active layer becomes smaller.

It may be regarded that the soft error is reduced because the potential difference is introduced across the base substrate and the active layer in such a direction that a back channel is formed in a vicinity of the interface of the insulator layer and the active layer, and a depletion layer and an inversion layer are formed thereby substantially reducing the thickness of the active layer. Accordingly, although the measured results described in conjunction with FIGS.8 and 9 were obtained for the 64k SOI-DRAM, it is evident that the effect of substantially reducing the thickness of the active layer can be obtained similarly in other semiconductor devices having the SOI structure.

In the first embodiment, the side surface of the semiconductor device is left as it is after being cut. For this reason, a leakage current easily flows from the base substrate 41 to the active layer 43 when the potential difference is introduced across the base substrate 41 and the active layer 43. Such a leakage current flows because moisture and foreign particles adhere on the side surface of the semiconductor device when the semiconductor device is exposed to the air and electricity can easily flow along the side surface of the semiconductor device. Accordingly, in the embodiments described hereunder, the semiconductor device has such a structure that the generation of the leakage current is prevented so as to improve the reliability of the semiconductor device.

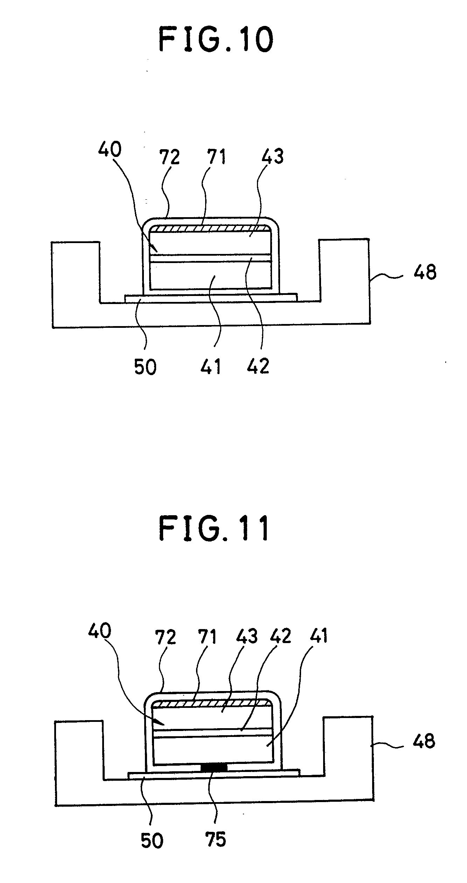

FIG.10 shows a second embodiment of the semiconductor device according to the present invention. In FIG.10, those parts which are essentially the same as those corresponding parts in FIG.4 are designated by the same reference numerals, and a description thereof will be omitted. In FIG.10, a cover layer 71 is formed on the active layer 43, and an insulator layer 72 for preventing the leakage current is formed on an outer peripheral surface of the stacked structure 40 to cover stacked structure 40 in its entirety. For example, a spin-on-glass layer having a thickness of 1 micron is used as the insulator layer 72. The stacked structure 40 is fixed on the package 48 after the insulator layer 72 is formed on the stacked structure 40.

FIG.11 shows a modification of the second embodiment. In FIG.11, those parts which are the same as those corresponding parts in FIG.10 are designated by the same reference numerals, and a description thereof will be omitted. In this modification, a contact portion 75 for supplying a voltage to the base substrate 41 is formed on the back surface of the base substrate 41.

In the second embodiment and the modification thereof, the insulator withstand voltage was approximately 50 V between the base substrate 41 and the active layer 43 when the insulator layer 72 has a thickness of 0.5 micron, for example. Hence, it was confirmed that the insulator withstand voltage becomes extremely high by the provision of the insulator layer 72 compared to the case where no insulator layer 72 is provided and the insulator withstand voltage is approximately 5 V.

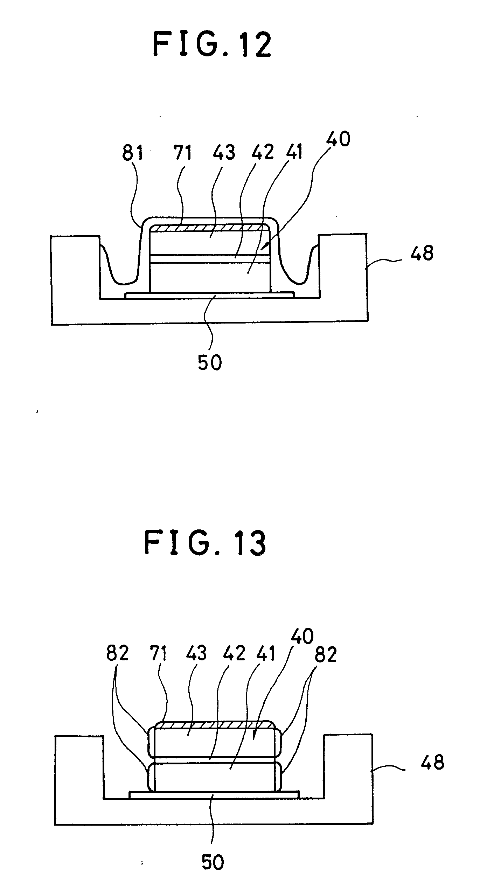

FIG.12 shows a third embodiment of the semiconductor device of the present invention. In FIG.12, those parts which are essentially the same as those corresponding parts in FIG.10 are designated by the same reference numerals, and a description thereof will be omitted. In this embodiment, the stacked structure 40 is fixed on the package 48 before an insulator layer 81 for preventing the leakage current is formed on the top and side surfaces of the stacked structure 40. For example, a polyimide system material or a spin-on-glass having a thickness of 1 micron is used as the insulator layer 81. The insulator withstand voltage was 35 V when the spin-on-glass was used as the insulator layer 81, and the insulator withstand voltage was 12 V when the polyimide system material was used as the insulator layer 81. In this embodiment, the number of production processes is reduced compared to the first embodiment since the insulator layer 81 is formed after the stacked structure 40 is fixed on the package 48, and the cost of the semiconductor device is accordingly reduced.

FIG.13 shows a fourth embodiment of the semiconductor device according to the present invention. In FIG.13, those parts which are essentially the same as those corresponding parts in FIG.10 are designated by the same reference numerals, and a description thereof will be omitted. In this embodiment, the stacked structure 40 is fixed on the package 48 before an insulator layer 82 for preventing the leakage current is formed on the side surface of the stacked structure 40. For example, the insulator layer 82 is formed by a plasma oxidation process. The insulator withstand voltage was 17 V when the insulator layer 82 was formed by the plasma oxidation process. In this embodiment, the number of production processes is also reduced compared to the first embodiment since the insulator layer 82 is formed after the stacked structure 40 is fixed on the package 48, and the cost of the semiconductor device is accordingly reduced.

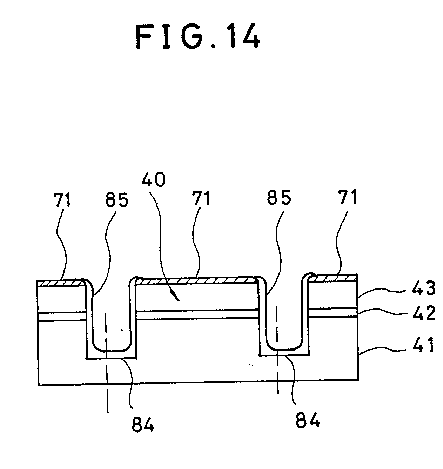

FIG.14 shows a fifth embodiment of the semiconductor device according to the present invention. In FIG.14, those parts which are essentially the same as those corresponding parts in FIG.10 are designated by the same reference numerals, and a description thereof will be omitted. In this embodiment, a U-shaped groove 84 which reaches the base substrate 41 is formed as shown, and an insulator layer 85 for preventing the leakage current is formed within the U-shaped groove 84. Thereafter, the base substrate 41 is cut at positions indicated by a phantom line so as to obtain the stacked structure 40, and this stacked structure 40 is fixed on a package (not shown). According to this embodiment, it is possible to produce semiconductor devices having a high insulator withstand voltage with a high yield.

According to the second through fifth embodiments described heretofore, the insulator layer for preventing the leakage current is formed on the side surface of at least one of the base substrate 41 and the active layer 43, so that the generation of the leakage current is prevented and the bias voltage can be applied stably with respect to the base substrate 41. Therefore, it is possible to improve the characteristic (reliability) of the semiconductor device and also improve the yield of the semiconductor device.

Further, the present invention is not limited to these embodiments, but various variations and modifications may be made without departing from the scope of the present invention.

## Claims

1. A semiconductor device comprising a base substrate (31, 41) made of a conductor or a semiconductor, an insulator layer (32, 42) formed on said base substrate, and an active layer (33, 43) in which elements are formed, said active layer being formed on said insulator layer and being made of a semiconductor, characterized in that there are provided: means (Vr) for introducing a potential difference across said base substrate (31, 41) and said active layer (33, 43) in such a direction that a depletion layer (34, 51) formed in a vicinity of an interface of said insulator layer (32, 42) and said active layer.

2. A semiconductor device as claimed in claim 1, characterized in that said base substrate (41), said insulator layer (42) and said active layer (43) constitute a stacked structure (40) and said means (Vr) applies the potential difference across said base substrate and said active layer from within said stacked structure.

3. A semiconductor device as claimed in claim 1, characterized in that said base substrate (41), said insulator layer (42) and said active layer (43) constitute a stacked structure (40) and said means (Vr) applies the potential difference across said base substrate and said active layer from outside said stacked structure.

4. A semiconductor device as claimed in claim 1, characterized in that said base substrate (41), said insulator layer (42) and said active layer (43) constitute a stacked structure (40), said semiconductor device further comprising a package (48) for accommodating said stacked structure.

5. A semiconductor device as claimed in any of claims 1, 3 and 4, characterized in that said means (Vr) includes means (75) for supplying a voltage to said base substrate (41) from a back surface of said base substrate.

6. A semiconductor device as claimed in any of claims 1, 3 and 4, characterized in that said means (Vr) includes means (55-57) for supplying a voltage to said base substrate (41) through said active layer (43) and said insulator layer (42).

7. A semiconductor device as claimed in any of claims 1 to 6, characterized in that there is further provided another insulator layer (72, 81, 82, 85) which covers at least a side surface of one of said base substrate (41) and said active layer (43).

8. A semiconductor device as claimed in claim 7, characterized in that said other insulator layer (72, 81, 82, 85) is made of a material selected from a group including spin-on-glass and polyimide system material.

9. A semiconductor device as claimed in claim 1, characterized in that said base substrate (41), said insulator layer (42) and said active layer (43) constitute a stacked structure (40), said semiconductor device further comprising another insulator layer (72, 81, 82, 85) which covers at least a side surface of said stacked structure.

10. A semiconductor device as claimed in claim 1, characterized in that said base substrate (41), said insulator layer (42) and said active layer (43) constitute a stacked structure (40), said semiconductor device further comprising another insulator layer (72, 81, 82, 85) which covers at least a top surface and a side surface of said stacked structure.

11. A semicondutor device as claimed in claim 1, characterized in that said base substrate (41), said insulator layer (42) and said active layer (43) constitute a stacked structure (40), said semiconductor device further comprising another insulator layer (72, 81, 82, 85) which covers said stacked structure in its entirety.

12. A semiconductor device as claimed in any of claims 1 to 11, characterized in that said means (Vr) applies the potential difference across said base substrate (31, 41) and said active layer (33, 43) in a direction to form a back channel in a vicinity of the interface of said insulator layer (32, 42) and said active layer.

# FIG.1 PRIOR ART

# FIG.2 PRIOR ART

# FIG. 3

33
34
32
31

$Vr$

# FIG. 4

46    45  43  42  41   40

51

48

47b   44    50     49

47a

# F I G. 5A

46

49

43

42

41

# F I G. 5B

46  49

56

43

42

41

55  57

# FIG. 6A

61    65

A

63

62

64

61

21 μm

B

18 μm

# FIG. 6B

63    62

66

65    70

A    n⁺    B

n⁺

P    67

68

69

# FIG. 7

SOI-DRAM

64K

CHECKER-BOARD
PATTERN

$_{95}Am_{241}$  $10\mu C$

SOI-DRAM

SOFT ERROR

64K

SOI-DRAM

EP 0 311 420 A2

# FIG. 8

Vcc = 5.0 V

$V_2$ = -3.0 V

$V_1$ = -3.0 V

# FIG. 9

SOFT ERROR(NORMALIZED VALUE)

5.5μm

8.6μm

15.8μm

Vcc = 5.0 V

V$_2$ = -3.0 V

1.5

1.0

-10        -5        0        5

BASE SUBSTRATE BIAS VOLTAGE    (V)

# FIG.10

# FIG.11

# FIG.12

# FIG.13

# FIG.14